# FASCICULE DE BREVET EUROPEEN

(11) **EP 0 715 760 B1**
(45) Date de publication et mention de la délivrance du brevet: **21.03.2001**
(21) Numéro de dépôt: 95921681.3
(22) Date de dépôt: 28.06.1995
(51) Int. Cl.: G11C 5/14, G11C 7/00

(54) **ETIQUETTE ELECTRONIQUE A LECTURE/ECRITURE OPTIQUE**
ELEKTRONISCHES ETIKETT ZUM OPTISCHEN LESEN/SCHREIBEN
ELECTRONIC LABEL WITH OPTICAL READING/WRITING

(30) Priorité: 04.07.1994 CH 212094
(43) Date de publication de la demande: 12.06.1996
(73) Titulaire: VALTAC, Alex Beaud, 1228 Plan-les-Ouates (CH)
(72) Inventeur: BERNEY, Jean, Claude, CH-1343 Les Charbonnières (CH)
(74) Mandataire: Frei, Alexandra Sarah
(86) Numéro de dépôt international: CH9500147
(87) Numéro de publication internationale: WO9601473

(56) Documents cités:
- DE-A- 4 138 131
- DE-U- 8 412 803
- FR-A- 2 623 311
- PATENT ABSTRACTS OF JAPAN vol. 12 no. 233 (P-724) ,5 Juillet 1988 & JP,A,63 025792 (URATA)
- PATENT ABSTRACTS OF JAPAN vol. 11 no. 216 (P-595) ,14 Juillet 1987 & JP,A,62 034291 (KOITO)
- PATENT ABSTRACTS OF JAPAN vol. 11 no. 216 (P-595) ,14 Juillet 1987 & JP,A,62 034292 (YAMADA)
- PATENT ABSTRACTS OF JAPAN vol. 17 no. 491 (P-491) ,6 Septembre 1993 & JP,A,05 126570 (MATSUSHITA)
- PATENT ABSTRACTS OF JAPAN vol. 12 no. 235 (P-725) ,6 Juillet 1988 & JP,A,63 027989 (HARADA)

## Description

Il existe actuellement sur le marché de nombreuses étiquettes électroniques permettant de mémoriser des informations en relation avec un objet ou un produit. Les plus simples ne comportent qu'une mémoire à lecture seule (ROM) dans lequel se trouve par exemple un numéro d'identification. Des systèmes plus évolués permettent la lecture et l'écriture, ce qui permet de modifier les informations mémorisées en fonction de l'évolution du produit dans le temps et d'assurer ainsi sa traçabilité. Parmi ces systèmes à lecture et écriture, les systèmes plus simples utilisent une mémoire statique (RAM) alimentée par une pile longue durée, par exemple par une pile au lithium. Parmi ces systèmes à lecture et écriture, des systèmes les plus sophistiqués utilisent des mémoires pouvant être effacées et programmées électriquement (EEPROM) qui ont l'avantage de conserver leur information sans apport d'énergie extérieure, ce qui permet de supprimer la pile. On peut accéder aux informations par exemple par un ou plusieurs contacts, comme dans les cartes à puce. Cependant on trouve de plus en plus de systèmes qui peuvent être lus, voir lus et écrits à distance, sans contacts. Pour ce faire, beaucoup de systèmes connus à ce jour utilisent un couplage magnétique, ce qui implique l'utilisation d'au moins une bobine. Cette manière de faire comporte différents inconvénients.

Par exemple on peut fixer une telle étiquette sur un objet métallique, lequel représente un court-circuit magnétique qui dérive l'énergie destinée à l'étiquette. On ne peut pas non plus placer plusieurs étiquettes à proximité les unes des autres car il y a risque d'interférences. Enfin la bobine est un composant relativement volumineux et délicat.

Le document DE-U-8412803.8 décrit une mémoire transportable pour mémoriser des données de machines d'imprimerie avec une mémoire et un circuit de commande, avec une unité d'entrée pour lire les données des machines d'imprimerie sans contacts et avec une unité de sortie pour écrire dans la mémoire des machines d'imprimerie sans contacts. Afin de fonctionner, cette mémoire transportable doit être insérée dans une machine d'imprimerie, elle ne fonctionne pas donc à distance. Les unités d'entrée et de sortie peuvent capter et émettre des signaux lumineux.

Le document FR-A-2623311 décrit les caractéristiques du préambule de la revendication 1 et montre un système d'identification à interrogation sans contact d'une étiquette électronique par une unité d'échange d'informations à proximité de laquelle est disposée l'étiquette. L'étiquette est dépourvue de source d'alimentation propre, elle comprend une mémoire électronique et une antenne unique permettant la réception de l'unité d'échange d'informations d'un rayonnement électromagnétique pour en dériver une tension continue d'alimentation et un signal codé d'interrogation et permettant l'émission à l'unité d'échange d'informations d'un rayonnement électromagnétique pour y transmettre un signal codé de réponse de l'étiquette.

Le document DE-A-4138131 montre une carte à puce avec mémoire pouvant être écrit à distance, sans contacts. Des informations à stocker dans la mémoire peuvent être transmises par des moyens capacitifs, optiques ou inductifs. Les informations stockées dans la mémoire sont visible sur écran. L'apport en énergie pour alimenter la carte à puce se fait par des cellules photovoltaïques en transformant de la lumière blanche.

Le document JP-62034291 montre un système de transfert de données à distance, sans contacts. Des informations stockées dans une mémoire d'une carte à puce peuvent être transmise grâce à un élément à émission de lumière. L'apport en énergie pour alimenter la carte à puce se fait par des cellules photovoltaïques en transformant de la lumière.

La présente invention concerne une étiquette électronique sans contacts à lecture ou lecture/écriture à distance qui ne présente pas les inconvénients susmentionnés. Cette étiquette est définie par les revendications.

La figure 1 représente à titre d'exemple le schéma de principe d'une étiquette selon l'invention.

La figure 2 représente à titre d'exemple un schéma plus détaillé de la mémoire avec son circuit de commande.

La figure 3 représente à titre d'exemple la constrution d'une étiquette selon l'invention.

La figure 4 représente à titre d'exemple une étiquette selon l'invention combinée avec un code bar.

La figure 5 représente à titre d'exemple une étiquette selon l'invention combinée avec une cible de centrage optique.

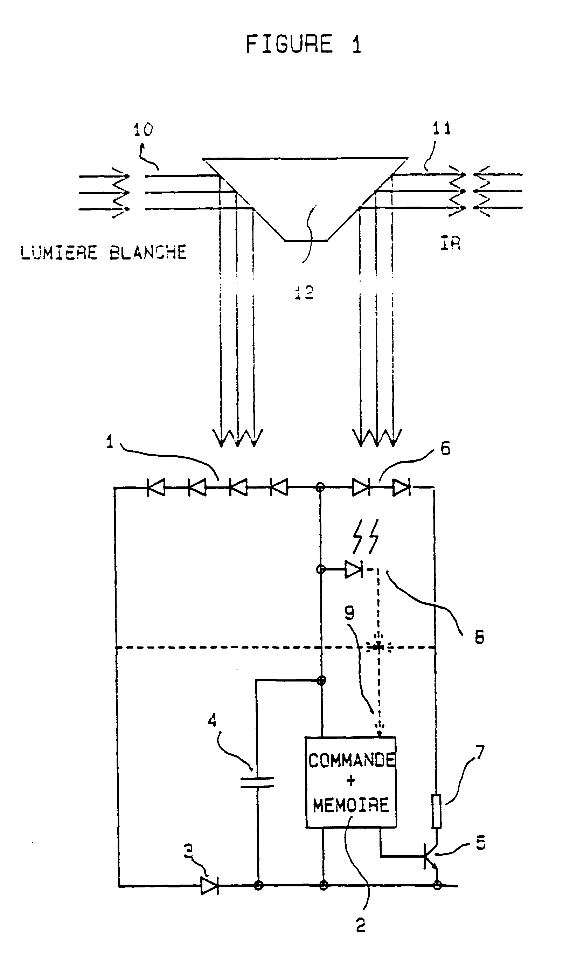

Sur la figure 1 on trouve 4 cellules électro-optiques 1, par exemple des cellules photo-voltaïques sur silicium amorphe ou des cellules AsGa sur silicium cristallin. Lorsque on dirige un rayon lumineux sur ces cellules, celles-ci délivrent une tension électrique permettant d'alimenter la mémoire avec son circuit de commande 2 par l'intermédiaire d'une diode 3 et d'une capacité 4 qui permettent de filtrer cette tension d'alimentation. De préférence le circuit de commande 2 comportera un circuit permettant de limiter cette tension d'alimentation en cas d'éclairage trop violent des cellules. Le circuit de commande 2 est relié à la base d'un transistor 5 qui alimente par exemple 2 diodes électroluminescentes 6 par l'intermédiaire d'une résistance 7. Il est ainsi possible, par l'intermédiaire de ces diodes électroluminescentes, d'envoyer vers l'extérieur des signaux lumineux en rapport avec le contenu de la mémoire. Ces signaux peuvent être détectés par des moyens connus. Par exemple si les diodes sont du type IR, on peut utiliser un détecteur IR tel ceux utilisés pour la détection de personne. Il est également possible d'envoyer des signaux lumineux par variation de la lumière incidente, c'est à dire par variation de la part du rayon lumineux qui est réfléchie par l'étiquette.

Dans la configuration la plus simple où la mémoire est de type à lecture seule, on pourrait imaginer que le circuit de commande 2 s'enclenche automatiquement lorsque la tension d'alimentation atteind une valeur suffisante, balaye en permanence la totalité de la mémoire et envoie les signaux correspondants par l'intermédiaire du transistor 5 sur les diodes 6. Il serait ainsi possible de lire en permanence le contenu de la mémoire tant que les cellules 1 sont suffisamment éclairées.

Toutefois cette configuration n'offre pas de gros avantages par rapport à un simple code bar. Une solution plus performante consiste à utiliser une mémoire à lecture/écriture de type EEPROM qui conserve ses informations en absence de source d'alimentation.

Il est alors nécessaire de pouvoir envoyer les informations à stocker dans la mémoire et commander les différentes séquences de lecture et d'écriture depuis l'extérieur.

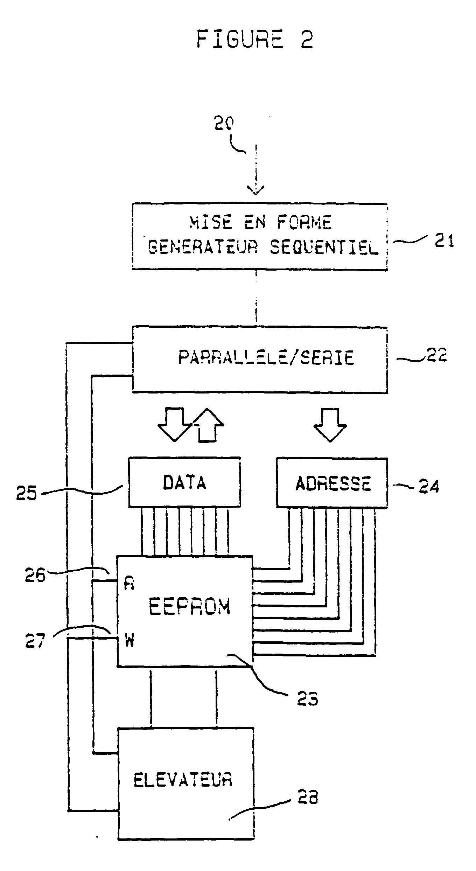

Pour cela, on peut peut par exemple moduler le rayon lumineux dirigé sur l'étiquette. Ces modulations peuvent être détectées par un détecteur optique, par exemple une photo-diode 8 reliée par une entrée 9 du circuit de commande 2 à un circuit d'amplification et de mise en forme de ce dernier. La configuration interne du circuit de commande 2 est donnée plus en détail à la figure 2.

Une autre solution plus simple consiste à utiliser directement tout ou partie des cellules électro-optiques 1 pour détecter ces modulations. En effet, ces cellules peuvent avoir un temps de réaction suffisamment faible pour introduire des signaux de commande par des interruptions courtes du rayon lumineux (modulation tout ou rien) à une fréquence de l'ordre de plusieurs kHz. Ces interruptions courtes sont filtrées par la diode 3 et la capacité 4 de telle manière que leur influence sur la tension d'alimentation soit négligeable. Les signaux de commande générés par les cellules 1 sont ensuite appliqués à l'entrée 9 du circuit de commande de la mémoire 2.

Une autre possibilité encore plus intéressante consiste à utiliser les diodes électroluminescentes 6 comme photodétecteurs. On sait en effet que ces éléments peuvent être réversibles et peuvent donc être utilisés comme émetteurs et récepteurs. Cette configuration permet de séparer totalement la partie apport d'énergie représenté par les cellules 1, et la partie émetteur-récepteur d'informations représentée par les diodes 6. Cette séparation peut se faire également au niveau de la longueur d'onde des faisceaux lumineux. Pour la partie apport d'énergie, on utilisera par exemple une lumière blanche similaire à la lumière solaire. Pour la partie émetteur-récepteur on travaillera de préférence en infra-rouge, ce qui donne une lumière beaucoup plus sélective et donc moins sensible aux perturbations extérieures. Dans le cas où les diodes 6 sont réversibles et utilisées également comme photo-détecteurs, c'est celles-ci qui sont reliées à l'entrée 9 du circuit de commande 2. Les 3 possibilités de branchement de l'entrée 9 sont représentées en pointillé sur la figure 1.

Dans le dernier exemple cité, l'apport d'énergie se fera donc en permanence en concentrant sur l'étiquette un rayon de lumière blanche 10, et la communication des informations par un rayon infra-rouge bidirectionnel 11. Le prisme 12 de la figure permet de combiner ces deux rayons de manière à représenter schématiquement le fonctionnement du système.

Notons qu'il existe de très nombreuses possibilités de générer ces rayons lumineux et de les envoyer sur la surface de l'étiquette, soit de manière directe, soit de manière indirecte par exemple par l'intermédiaire de fibres optiques.

La figure 2 représente à titre d'exemple la configuration interne de ce circuit de commande avec la mémoire associée.

Les signaux de commande 20 sont appliqués à l'entrée d'un circuit de mise en forme 21 qui génère les différentes séquences de fonctionnement de l'étiquette et délivre des signaux rectangulaires à l'entrée d'un convertisseur série/parallèle 22. Ce convertisseur est agencé de manière à décoder les informations transmises de l'extérieur sous forme série par l'intermédiaire du rayon lumineux de manière à commander la mémoire 23 avec ses entrées d'adresse 24, ses entrées-sorties de datas 25, de lecture 26 et d'écriture 27. Il existe de nombreuses configurations de ce genre connues des gens de métier et nous n'entrerons donc pas dans les détails. Ajoutons simplement que ce genre de mémoire EEPROM comporte généralement un élévateur de tension 28 qui s'enclenche lors de l'écriture et permet de fixer les nouveaux datas à enregistrer.

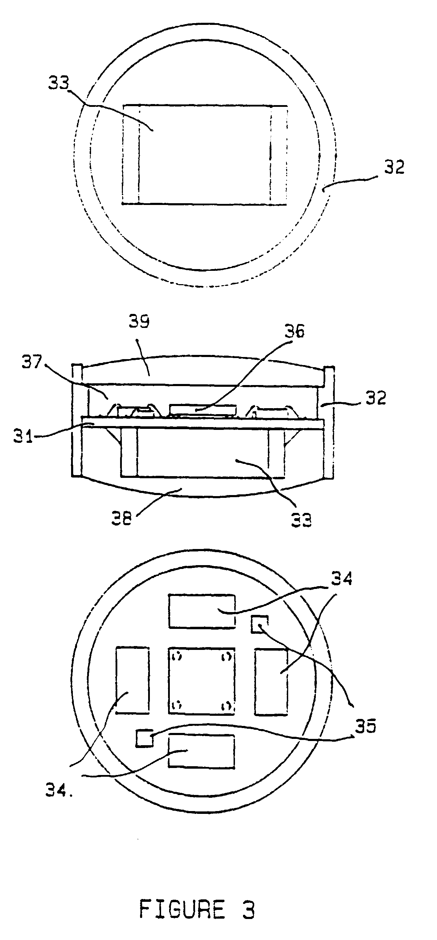

La figure 3 représente à titre d'exemple la construction d'une étiquette selon l'invention.

Sur cette figure, les différents éléments électroniques sont motés sur un support 31 fixé dans un boitier tubulaire 32. D'un côté du support 31, on trouve le condensateur 33 (4 de la fig.1). Sur l'autre face on trouve les 4 cellules électro-optiques 34 et les deux diodes électroluminescentes 35, ainsi qu'un circuit intégré 36 comprenant le circuit de commande et la mémoire ainsi que la diode (3 de la fig.1).

Dans une construction classique, le support 31 peut être un circuit imprimé double-face comprenant les interconnexions entre les différents composants. Le condensateur 33, du type SMD, est soudé directement sur le circuit imprimé. Le circuit intégré 36 peut comporter des bumps et être fixé par thermocompression, alors que les éléments électro-optiques sont connectés par bonding 37.

Ce type de montage est donné à titre d'exemple pour la compréhension de l'invention. Cependant il y a actuellement une évolution rapide des méthodes de micromontage permettant par exemple de grouper plusieurs éléments sur un même substrat de manière à limiter le nombre de composants et d'interconnexions, si bien qu'on peut s'attendre à de notables simplifications de celui-ci dans le futur.

Il est temps maintenant de parler du dimensionnement de ce type d'étiquette. Typiquement les sources de lumières simples comme les diodes laser peuvent émettre un rayon lumineux d'une intensité de l'ordre de 100 mW pour 1 cm². Les cellules électro-optique connues à ce jour ont un rendement de l'ordre de 10%. On peut ainsi obtenir une puissance électrique de 0,1 mW par mm² de surface de cellule.

Pour écrire un byte dans une mémoire EEPROM, il faut enclencher un élévateur de tension et fournir une certaine puissance. Cette puissance est typiquement pour des cellules connues à ce jour de 2,5 mW pendant 2,5 ms (Faselec®).

Pour envoyer des informations vers l'extérieur, il faut typiquement alimenter les diodes électroluminescentes avec au moins lmA pour que celles-ci délivrent des signaux lumineux facilement détectables, ce qui représente 5 mW sous 5 Volts.

Pour obtenir une telle puissance, il faudrait avoir une surface totale des cellules de 50 mm². Cela conduirait à avoir des étiquettes relativement grandes et coûteuses. Un moyen simple consiste à travailler en temps partagé. Cela signifie que l'on ne va écrire ou envoyer des signaux lumineux que pendant des durées très courtes pendant lesquelles la puissance est prélevée sur la capacité de filtrage, suivies de durées plus longues pendant lesquelles cette capacité est rechargée. On arrive ainsi à une puissance moyenne beaucoup plus faible.

Pour l'écriture, par exemple, nous avons vu qu'il fallait fournir 2,5 mW pendant 2,5 ms pour écrire 1 byte. Pour diminuer la puissance moyenne, il suffit ensuite de recharger la capacité pendant 7,5 ms ce qui donne un cycle d'écriture de total de 10 ms. La puissance moyenne est de 2,5mW*2,5/(2,5+7,5)= 0,625 mW.

Pour envoyer des signaux vers l'extérieur, nous avons vu qu'il fallait 5mW. Par contre les diodes IR peuvent être modulées à grande vitesse si bien que l'on pourra envoyer un byte en quelques microsecondes, si bien que la puissance moyenne peut facilement être réduite à 10% de la valeur de pointe, soit 0,5 mW.

Ces différents rapports cycliques peuvent être générés directement par le circuit de commande de la figure 2.

Ainsi la surface totale des cellules peut facilement être réduite de 8 à 10 fois, ce qui représente par exemple 4 cellules de 2 mm². Le circuit intégré comportant la mémoire avec son circuit de commande et la diode a typiquement une surface de 4 mm² (techno Faselec® SAC MOS 2 microns, capacité de 256/8 bits). Les diodes électroluminescentes pour leur part dépassent pas 0,5mm/0,5mm.

Lors de l'écriture, la capacité doit pouvoir délivrer un courant de 0,5 mA pendant 2,5 ms avec une chute de tension acceptable. Il faut donc une valeur de l'ordre du microFarad. C'est pourquoi il faut un condensateur SMD grandeur 1812 au minimum.

Notons que ces évaluations de puissance correspondent à l'état actuel de la technique pour des composants disponibles sur le commerce. On parle déjà de mémoires EEPROM qui demanderaient 10 fois moins de puissance pour l'écriture, ce qui permettrait de réduire en conséquence les dimensions.

Dans l'exemple représenté, le tout peut être montré comme représenté sur la figure 3 dans un boîtier tubulaire 32 de 8 mm de diamètre et de 4 mm de haut (échelle 8). Le boîtier est rendu étanche d'un côté par une goutte de résine 38, et de l'autre par une lentille transparente 39 fixée dans un dégagement de ce boîtier.

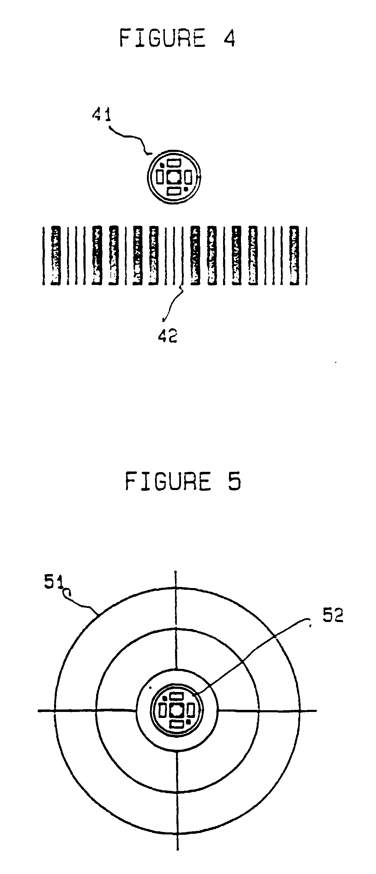

La figure 4 représente à titre d'exemple une étiquette selon l'invention combinée avec un code bar.

Pour utiliser l'étiquette selon l'invention, on envoye un rayon lumineux et on reçoit en retour des signaux lumineux codés. Il y a donc une très grande analogie avec les moyens nécessaires pour lire un code bar. On pourrait donc combiner l'étiquette 41 selon l'invention avec un code bar 42, ce dernier représentant la partie fixe de l'information (identification) et l'étiquette selon l'invention la partie modifiable de celle-ci.

La figure 5 représente à titre d'exemple une étiquette selon l'invention combinée à une cible optique.

On sait que les moyens de reconnaissance d'image ont beaucoup progressé ces derniers temps. Ces moyens permettent par exemple de faire du positionnement de précision. Dans notre cas de tels moyens de reconnaissance d'image, associés à une cible 51, permettrait de diriger avec précision le rayon lumineux sur l'étiquette 52 placée en son centre.

Il existe bien de nombreuses autres combinaisons pour réaliser l'étiquette selon l'invention, mais la description de celles-ci n'apporterait pas d'éléments supplémentaires pour la compréhension de son fonctionnement.

## Revendications

1. Etiquette comportant :
au moins une mémoire (23) électronique capable de conserver son état en l'absence de source d'alimentation et
un circuit de commande (2) de cette mémoire (23),
**caractérisée par le fait**
que l'étiquette comporte au moins une combinaison de cellules (1,34) de type électro-optiques agencées de manière à alimenter la mémoire (23) et son circuit de commande (2) lorsque des rayons lumineux de lumière blanche (10) sont envoyés sur la surface desdites cellules (1,34),
que l'étiquette comporte des moyens de transmission (6,35) reliés audit circuit de commande (2) agencés de manière à transmettre vers l'extérieur des signaux lumineux infra-rouge (11) en rapport avec le contenu de la mémoire (23),
que l'étiquette comporte des moyens de détection (8,35) de signaux obtenus par modulation de rayons lumineux et
que ces moyens de détection (8,35) étant agencés de manière à commander le circuit de commande (2) de l'extérieur au moyen desdits signaux.

2. Etiquette selon la revendication 1, **caractérisé par le fait** que lesdits moyens de transmission sont du type optoélectronique à émission de lumière (6).

3. Etiquette selon la revendication 1, **caractérisé par le fait** que lesdits signaux sont obtenus par modulation de rayons lumineux infra-rouge.

4. Etiquette selon la revendication 1, **caractérisé par le fait** que les cellules (1,35) de type électro-optiques sont également des moyens de détection (8) de signaux obtenus par modulation des rayons lumineux de lumière blanche (10), que l'étiquette comporte des moyens de mise en forme (3,4) de ces signaux détectés par les cellules (1,35) et que ces moyens de détection (8) et ces moyens de mise en forme (3,4) étant agencés de manière à commander le circuit de commande (2) de la mémoire (23) de l'extérieur au moyen desdits signaux.

5. Etiquette selon la revendication 4, **caractérisé par le fait** que tout ou une partie des cellules (1,35) de type électro-optiques sont des moyens de détection de signaux obtenus par modulation des rayons lumineux de lumière blanche (10).

6. Etiquette selon la revendication 1, **caractérisé par le fait** que les moyens de transmission (6,35) sont de type réversible et ainsi également des moyens de détection (8) de signaux obtenus par modulation de rayons lumineux de lumière infra-rouge et que ces moyens de détection de transmission (6) étant agencés de manière à commander le circuit de commande (2) de l'extérieur au moyen desdits signaux.

7. Etiquette selon une des revendications 1 à 6, **caractérisé par le fait** qu'elle est positionné à proximité d'un code bar (42), les rayons lumineux de lumière blanche (10) étant associé à des moyens agencés pour lire ledit code bar (42).

8. Etiquette selon une des revendications 1 à 7, **caractérisé par le fait** qu'elle est positionné dans une cible (51) optique, les rayons lumineux de lumière blanche (10) étant associé à des moyens de reconnaissance d'image agencés de manière à diriger lesdits rayons lumineux sur l'étiquette par reconnaissance de la cible (51).

## Patentansprüche

1. Etikett mit zumindest einem elektronischen Speicher (23), der seinen Zustand ohne Versorgungsquelle bewahren kann, und mit einem Steuerschaltkreis (2) für diesen Speicher (23),
dadurch gekennzeichnet, dass
das Etikett zumindest eine Zusammenstellung von elektrooptische Zellen (1, 34) aufweist, die der Versorgung des Speichers (23) und seines Steuerschaltkreises (2) dienen, wenn Lichtstrahlen von weissem Licht (10) auf die Oberfläche der genannten Zellen (1, 34) auftreffen,
dass das Etikett Übertragungselemente (6, 35) aufweist, die mit dem genannten Steuerschaltkreis (2) verbunden und so angeordnet sind, dass sie Infrarotlichtsignale (11) bezüglich des Inhalts des Speichers (23) nach aussen übertragen,
dass das Etikett Ortungselemente (8, 35) für Signale aufweist, die durch Modulation von Lichtstrahlen erhalten werden und
dass diese Ortungselemente (8, 35) so eingerichtet sind, dass sie den Steuerschaltkreis (2) von aussen mit Hilfe der genannten Signale steuern können.

2. Etikett nach Anspruch 1, dadurch gekennzeichnet, dass die genannten Übertragungselemente optoelektronischer Art für die Emission von Licht (6) sind.

3. Etikett nach Anspruch 1, dadurch gekennzeichnet, dass die genannten Signale durch Modulation von Infrarotlichtstrahlen erhalten werden.

4. Etikett nach Anspruch 1, dadurch gekennzeichnet, dass die Zellen (1, 35) der elektro-optischen Art Ortungselemente (8) für Signale sind, die durch Modulation der Lichtstrahlen von weissem Licht (10) erhalten werden, dass das Etikett Formelemente (3, 4) für diese durch die Zellen (1, 35) georteten Signale aufweist und dass diese Ortungselemente (8) und diese Formelemente (3, 4) so aufgebaut sind, dass sie den Steuerschaltkreis (2) des Speichers (23) von aussen mit Hilfe der genannten Signale steuern.

5. Etikett nach Anspruch 4, dadurch gekennzeichnet, dass alle oder ein Teil der Zellen (1, 35) der elekro-optischen Art Ortungselemente für Signale sind, die durch Modulation der Lichtstrahlen von weissem Licht erhalten werden.

6. Etikett nach Anspruch 1, dadurch gekennzeichnet, dass die Übertragungselemente (6, 35) reversibel und somit ebenso Ortungselemente (8) für Signale sind, die durch Modulation von Infrarotlichtstrahlen erhalten werden, und dass die Ortungselemente der Übertragung (6) so aufgebaut sind, dass sie den Steuerschaltkreis (2) von aussen mit Hilfe der genannten Signale steuern.

7. Etikett nach einem der Ansprüche 1 - 6, dadurch gekennzeichnet, dass es in der Nähe eines Strichcodes (42) angeordnet wird, wobei die Lichtrahlen von weissem Licht (10) mit Elementen für das Lesen des genannten Strichcodes (42) verbunden werden.

8. Etikett nach einem der Ansprüche 1 -7, dadurch gekennzeichnet, dass es in einem optischen Ziel (51) angeordnet ist, wobei die Lichtstrahlen des weissen Lichts (10) mit Bilderkennungselementen verbunden werden, die so aufgebaut sind, dass sie die genannten Lichtstrahlen auf das Etikett leiten durch Erkennung des Ziels (51) ausrichten.

## Claims

1. Label comprising:
at least one electronic memory (23) capable of preserving its state in the absence of a power supply and
a control circuit (2) for this memory (23),
characterized
in that the label comprises at least one combination of cells (1, 34) of electrooptical type configured in such a way as to power the memory (23) and its control circuit (2) when light rays of white light (10) are sent onto the surface of the said cells (1, 34),
in that the label comprises transmission means (6, 35) linked to the said control circuit (2) and configured in such a way as to transmit to the outside infrared light signals (11) related to the content of the memory (23),
in that the label comprises means (8, 35) for detecting signals obtained by modulation of light rays, and
in that these detection means (8, 35) being configured in such a way as to control the control circuit (2) from outside by means of the said signals.

2. Label according to Claim 1, characterized in that the said transmission means are of the light-emission optoelectronic type (6).

3. Label according to Claim 1, characterized in that the said signals are obtained by modulation of infrared light rays.

4. Label according to Claim 1, characterized in that the cells (1, 35) of electrooptical type are also means (8) for detecting signals obtained by modulation of the light rays of white light (10), in that the label comprises means (3, 4) for shaping these signals detected by the cells (1, 35) and in that these detection means (8) and these shaping means (3, 4) being configured in such a way as to control the control circuit (2) of the memory (23) from outside by means of the said signals.

5. Label according to Claim 4, characterized in that all or some of the cells (1, 35) of electrooptical type are means for detecting signals obtained by modulation of the light rays of white light (10).

6. Label according to Claim 1, characterized in that the transmission means (6, 35) are of reversible type and thus also means (8) for detecting signals obtained by modulation of light rays of infrared light and in that these transmission detection means (6) being configured in such a way as to control the control circuit (2) from outside by means of said signals.

7. Label according to one of Claims 1 to 6, characterized in that it is positioned in proximity to a bar code (42), the light rays of white light (10) being associated with means configured so as to read the said bar code (42).

8. Label according to one of Claims 1 to 7, characterized in that it is positioned in an optical target (51), the light rays of white light (10) being associated with image recognition means configured in such a way as to direct the said light rays onto the label by recognition of the target (51).
